# EUROPEAN PATENT APPLICATION

(11) **EP 0 527 572 A1**
(43) Date of publication of application: **17.02.1993**
(21) Application number: 92306827.4
(22) Date of filing: 27.07.1992
(51) Int. Cl.: C08G 61/02, G03F 7/027, G03F 7/16, C08J 5/18

(54) **Formation of benzocyclobutene resin films**

(30) Priority: 09.08.1991 JP 223684/91
(71) Applicant: NEC CORPORATION, Tokyo (JP)
(72) Inventor: Shimoto, Tadanori, Minato-ku, Tokyo 108-01 (JP); Matsui, Koji c/o NEC Corporation, Minato-ku, Tokyo108-01 (JP)
(74) Representative: Harland, Linda Jane

(57) **Abstract**

A benzocyclobutene resin film having excellent flexibility, film strength and anti-cracking properties as well as chemical stability is prepared. A bisbenzocyclobutene monomer is polymerized in the presence of an unsaturated compound having a higher dienophile activity than the bisbenzocyclobutene monomer. A benzocyclobutene resin precursor composition comprising at least a bisbenzocyclobutene monomer and an unsaturated compound having a higher dienophile activity than the bisbenzocyclobutene monomer can more advantageously be used.

## Description

### BACKGROUND OF THE INVENTION

### Field of the Invention

This invention relates to a process for forming a benzocyclobutene resin film having not only excellent flexibility and film strength but also excellent chemical stability.

### Description of the Prior Art

In the case where a benzocyclobutene resin material is used as a layer insulating film for multilayered wiring boards, there is so far known a technique of forming a benzocyclobutene resin insulating film which can provide good interlayer adhesion, in which an insulating film is formed by polymerizing a bisbenzocyclobutene monomer by allowing it to undergo a heat experience such that conversion of the bisbenzocyclobutene monomer may be less than 100 %; forming such insulating films under the same conditions and laminating them, successively, to provide a multilayered film; and allowing only the last layer to undergo a heat experience such that conversion of the bisbenzocyclobutene monomer may be 100 %. (e.g. Benzocyclobutene (BCB) Dielectrics for Fabrication of High Density, Thin Film Multichip Modules: Journal of Electronic Materials, Vol. 19, No. 12, 1990).

According to the above prior art process for forming a benzocyclobutene resin layer insulating film, a cured film obtained after all comes to have a bisbenzocyclobutene monomer conversion of 100 %.

However, the cured film in which conversion of the bisbenzocyclobutene monomer is 100 % is brittle and has poor flexibility, disadvantageously. Accordingly, if such cured film is used as a layer insulating film in a multilayered wiring board, it causes problems such as cracking and delamination of conductor layers from the substrate.

Meanwhile, a cured film obtained by undergoing a heat experience in such a way that conversion of the bisbenzocyclobutene monomer may be less than 100 % has excellent film strength and excellent flexibility. However, such cured film has poor chemical stability, so that that the conversion is liable to proceed up to 100 % when a multilayered wiring board formed by building up such cured films having a conversion of less than 100 % is subjected to sputter film formation in forming conductor layers or to ion-beam etching of the sputter films. Otherwise, when the wiring board is integrated into an apparatus and actuated, conversion of the cured film is liable to proceed by the heat generated during operation of the apparatus, and such cured film suffers poor reliability in various aspects, disadvantageously. On the other hand, with reference to the properties of the material of the cured film, the cured film in which conversion of the bisbenzocyclobutene monomer is less than 100 % cannot give the intended values, for example, in electrical properties.

Due to the reasons described above, use of a cured film in which conversion of the bisbenzocyclobutene monomer is 100 % is desirable.

### SUMMARY OF THE INVENTION

The present invention provides in one aspect a process for forming a benzocyclobutene resin film by polymerizing a bisbenzocyclobutene monomer, which comprises subjecting a bisbenzocyclobutene monomer to polymerization in the presence of an unsaturated compound having a higher dienophile activity than the bisbenzocyclobutene monomer.

According to another aspect of this invention, there is provided a benzocyclobutene resin precursor composition comprising at least a bisbenzocyclobutene monomer and an unsaturated compound having a higher dienophile activity than the bisbenzocyclobutene monomer, wherein the unsaturated compound having a dienophile activity is added in an amount of 0.001 to 0.2 mol per mol of the bisbenzocyclobutene monomer.

The process for forming a benzocyclobutene resin film according to this invention preferably includes use of the above benzocyclobutene resin precursor composition and an ultraviolet irradiation under a nitrogen/oxygen mixed gas atmosphere.

The dienophile used herein means an unsaturated compound having an electron attractive substituent at the α-position, and can typically be exemplified by the general formula:

(R¹)(R²)C=C(R³)(R⁴) or R⁵-C≡R⁶

wherein at least one of R¹ to R⁶ represents an electron attractive substituent such a carboxyl group, an alkoxycarbonyl group, an acyl group, an aldehyde group, a nitrile group, a nitro group, a halogen atom, an acetoxy group, a phenyl group, a sulfone group, an oxymethyl group, an aminomethyl group and a cyanomethyl group.

The dienophile may otherwise be those having cyclic structures such as p-benzoquinone and maleic anhydride or those having no carbon backbone structures such as azodicarboxylic acid (or derivatives thereof). It is also possible to use a singlet oxygen and the like as the dienophile.

Polymerization of a bisbenzocyclobutene monomer in the presence of an unsaturated compound having a higher dienophile activity than the bisbenzocyclobutene monomer allows the reactive arylcyclobutene participating in the bisbenzocyclobutene monomer polymerization to partially react with the dienophile to form an adduct. Accordingly, the part of the acrylcyclobutene reacted with the dienophile assumes inert in the polymerization, and the polymerization degree of the bisbenzocyclobutene monomer can be controlled by this adduct.

Therefore, even if the bisbenzocyclobutene monomer is allowed to undergo a heat experience so that the conversion of the bisbenzocyclobutene monomer may proceed 100 %, a layer insulating film having the same properties as those of a cured film of less than 100 % conversion can be formed. Thus, the resulting benzocyclobutene resin insulating film comes to have excellent flexibility, film strength and anti-cracking properties.

The insulating film prepared according to this invention is of a cured film in which conversion of the bisbenzocyclobutene monomer is 100 %, so that it has excellent chemical stability. Accordingly, if it is applied as a layer insulating film, for example, in a multilayered wiring board, it can show reliability over an extended period. The insulating film obtained according to such method retains the original performance of the benzocyclobutene resin in terms of electrical properties etc.

If an ultraviolet irradiation is applied in a nitrogen/oxygen mixed gas atmosphere during the polymerization of the bisbenzocyclobutene monomer, the polymerization reaction can be accelerated to give a cured film of 100 % conversion in a shorter time.

The benzocyclobutene resin precursor composition containing a bisbenzocyclobutene monomer and a dienophile, according to this invention, can suitably be used in the process for forming a benzocyclobutene resin film according to this invention, and the composition has excellent storage stability.

### DETAILED DESCRIPTION OF THE PREFERRED EMBODIMENTS

The present invention will now be described more specifically by way of examples.

### Example 1

To a solution of a bisbenzocyclobutene monomer dissolved in a solvent primarily containing xylene was added 0.025 mol of maleic anhydride per mol of the bisbenzocyclobutene monomer at room temperature to provide a benzocyclobutene resin precursor composition.

The thus prepared composition was applied onto a silicon wafer by means of spin coating method to form a film, followed by heating under nitrogen stream in an oven at 100°C for 30 minutes, at 150°C for 30 minutes and then at 230°C for one hour, to achieve 100 % conversion of the bisbenzocyclobutene monomer. Measurement of conversion was identified by FT-IR.

The cured film obtained by heating was peeled off from the silicon wafer by immersing it in a 40 % hydrofluoric acid to evaluate properties of the cured film. It was thus found that the cured film has excellent film strength and flexibility and can hardly be broken.

### Example 2

The same benzocyclobutene resin precursor composition as used in Example 1 was applied on a silicon wafer by means of spin coating method to form a film.

When the thus formed film was subjected to heat treatment using a hot plate oven at 100°C for 20 minutes, at 150°C for 20 minutes and then at 230°C for 30 minutes under a mixed gas atmosphere containing nitrogen and a very small amount of oxygen (oxygen concentration: 300 ppm) with ultraviolet irradiation using a 1 kW high-pressure mercury lamp, 100 % conversion of the bisbenzocyclobutene monomer was achieved.

The thus obtained cured film was evaluated in the same manner as in Example 1 to find that it has excellent film strength and flexibility and cannot hardly be broken.

### Comparative Example 1

A solution of a bisbenzocyclobutene monomer dissolved in a solvent primarily containing xylene to which no dienophile was admixed was applied onto a silicon wafer by means of spin coating methOd to form a film, in the same manner as in Example 1, followed by heating in an oven under nitrogen stream at 100°C for 30 minutes, at 150°C for 30 minutes and then at 250°C for one hour, to achieve 100 % conversion of the bisbenzocyclobutene monomer.

When the cured film obtained by heating was peeled off from the silicon wafer by immersing it in a 40 % hydrofluoric acid, the cured film was found to have poor flexibility and can easily be broken into pieces.

### Example 3

The same composition containing a bisbenzocyclobutene monomer and maleic anhydride as used in Example 1 was applied onto an alumina ceramic substrate by means of spin coating method to form a film, followed by heating in an oven under nitrogen stream at 100°C for 30 minutes, at 150°C for 30 minutes and then at 200°C for 45 minutes, to form a cured film having a film thickness of 10 µm.

A metal layer primarily containing copper was then formed on the cured film. Upon formation of the metal layer, the above composition was applied again on the entire surface of the metal layer by means of spin coating to form a film, and the film was cured under the same heating conditions as described above. These procedures were repeated to form a multilayered wiring board having 10 metal layers. No cracking was observed in the thus obtained multilayered wiring board.

### Comparative Example 2

A solution of a bisbenzocyclobutene monomer dissolved in a solvent primarily containing xylene to which no dienophile was admixed was applied onto an alumina ceramic substrate by means of spin coating method to form a film, in the same manner as in Example 3, followed by heating in an oven under nitrogen stream at 100°C for 30 minutes, at 150°C for 30 minutes and then at 220°C for 45 minutes, to form a cured film having a film thickness of 10 µm.

A metal layer primarily containing copper was then formed on the cured film. When a multilayered wiring board was prepared by repeating the above procedures, cracking was observed during the process of laminating 7th metal layer.

The crack grew by carrying out further lamination and the benzocyclobutene resin layers finally peeled off from the alumina ceramic substrate.

As has been described heretofore, the process for forming a benzocyclobutene resin film by bisbenzocyclobutene monomer polymerization according to this invention can effectively give a film having excellent flexibility, film strength and anti-cracking properties by carrying out polymerization of the bisbenzocyclobutene monomer in the presence of an unsaturated compound having dienophile activity.

Meanwhile, the benzocyclobutene resin film formed according to the present process has excellent chemical stability, since 100 % conversion of the bisbenzocyclobutene monomer is achieved.

Further, the benzocyclobutene resin precursor composition according to this invention can readily afford a benzocyclobutene resin film having excellent properties as described above and has excellent storage stability.

Although three embodiments of the present invention have been described herein, it should be apparent to those skilled in the art that the present invention may be embodied in many other specific forms without departing from the scope of the invention.

Therefore, the present example and embodiment are to be considered as illustrative and not restrictive and the invention is not to be limited to the details given herein, but may be modified within the scope of the appended claims.

## Claims

1. A process for forming a benzocyclobutene resin film by polymerizing a bisbenzocyclobutene monomer, which comprises subjecting a bisbenzocyclobutene monomer to polymerization in the presence of an unsaturated compound having a higher dienophile activity than the bisbenzocyclobutene monomer.

2. The process for forming a benzocyclobutene resin film according to Claim 1, which further involves a step of irradiating ultraviolet light under a mixed gas atmosphere of nitrogen and oxygen.

3. A benzocyclobutene resin precursor composition comprising at least a bisbenzocyclobutene monomer and an unsaturated compound having a higher dienophile activity than the bisbenzocyclobutene monomer, wherein said unsaturated compound having a higher dienophile activity is added in an amount of 0.001 to 0.2 mol per mol of the bisbenzocyclobutene monomer.

4. The process for forming a benzocyclobutene resin film according to Claim 1, wherein the benzocyclobutene resin precursor composition as claimed in Claim 3 is used.
